# FASCICULE DE BREVET EUROPEEN

(11) **EP 1 813 018 B1**
(45) Date de publication et mention de la délivrance du brevet: **14.10.2009**
(21) Numéro de dépôt: 05817343.6
(22) Date de dépôt: 08.11.2005
(51) Int. Cl.: H03L 7/089

(54) **CIRCUIT DE CONVERSION TEMPS-TENSION SYMETRIQUE**
SYMMETRISCHE ZEIT/SPANNUNGS-UMSETZUNGSSCHALTUNG
SYMMETRICAL TIME/VOLTAGE CONVERSION CIRCUIT

(30) Priorité: 15.11.2004 FR 0412082
(43) Date de publication de la demande: 01.08.2007
(73) Titulaire: COMMISSARIAT A L'ENERGIE ATOMIQUE, 75015 Paris (FR)
(72) Inventeur: MASSON, Gilles, F-38140 Renage (FR)
(74) Mandataire: Bonnans, Arnaud
(86) Numéro de dépôt international: PCT/FR2005/002783
(87) Numéro de publication internationale: WO 2006/051212

(56) Documents cités:
- EP-A- 0 647 032
- US-A- 5 532 636
- US-A- 5 687 201
- US-B1- 6 469 554

## Description

La présente invention se rapporte à la conversion du temps en tension, appelée ci-après conversion temps-tension.

Elle trouve une application dans les circuits électroniques devant produire des horloges déphasées avec une grande précision, à partir d'une horloge de référence très haute fréquence, typiquement supérieure à 1 GHz.

Ainsi, elle trouve une application dans les systèmes à boucle de verrouillage de phase, appelés encore « PLL » pour *Phase Locked Loop* ou « DLL », pour *Delay Locked Loop,* dans lesquels il est nécessaire de convertir un décalage temporel en une tension proportionnelle avec une grande précision.

L'architecture classique d'un système à boucle de verrouillage de phase est une pompe de charge, appelée encore charge *pump* en anglais. Généralement, une pompe de charge génère à partir de deux signaux logiques, appelés encore *Up* (incrément) ou *Down,* (décrément), une tension proportionnelle à la différence de durée de ces deux signaux. Cette différence est mémorisée pour être intégrée dans le temps.

Par exemple, les signaux logiques Up et Down sont des signaux de commande issus d'un détecteur de phase et sont l'image du décalage de phase entre deux signaux horloges que l'on veut synchroniser parfaitement. Lorsque les deux horloges ne sont pas encore synchronisées, les signaux Up et Down ont des durées différentes. C'est cette différence de durée que l'on veut convertir en une tension proportionnelle, puis intégrer dans le temps, afin de corriger l'écart par l'intermédiaire d'une boucle de contre réaction.

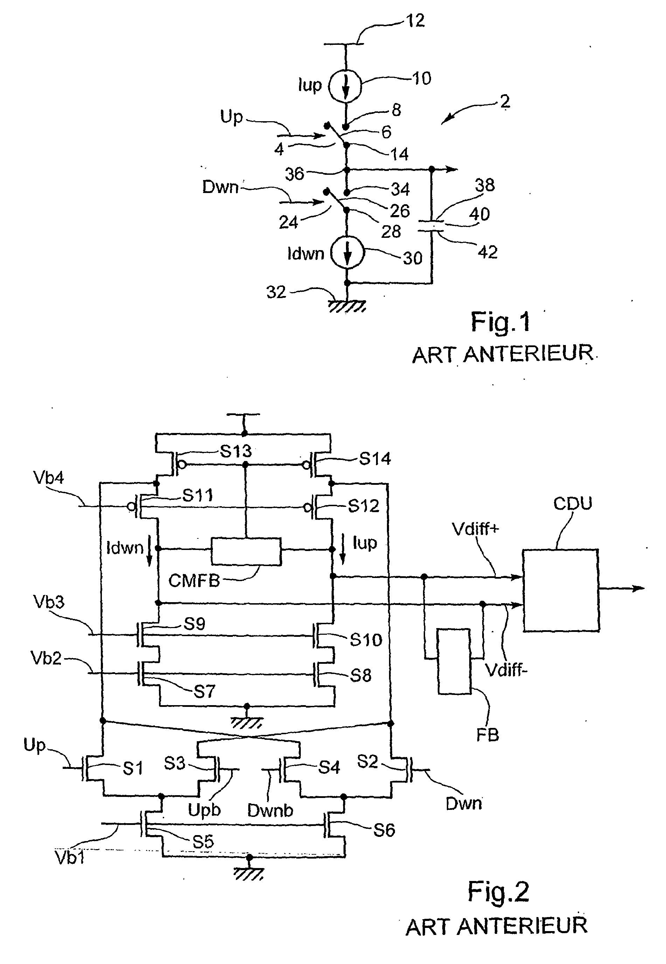

En référence à la **figure 1**, un circuit de conversion 2 de l'art antérieur comprend deux interrupteurs 4 et 24. L'interrupteur 4 comprend une entrée de commande 6 recevant le signal Up, une branche d'entrée 8 reliée à une source de courant 10 et une branche de sortie 14. La source de courant 10 est reliée à une borne d'alimentation positive 12. L'interrupteur 24 comprend une entrée de commande 26 recevant le signal Dwn, une branche d'entrée 34 et une branche de sortie 28 reliée à une source de courant 30. La source de courant 30 est reliée à une borne d'alimentation 32 (masse). La branche de sortie 14 de l'interrupteur 4 et la branche d'entrée 34 de l'interrupteur 24 sont reliées l'une à l'autre au noeud 36. Une borne 38 d'une capacité 40 est reliée au noeud 36. L'autre borne 42 de la capacité 40 est reliée à la sortie de la source de courant 30.

Lorsque les courants lup et Idwn des deux sources de courant 10 et 30 sont parfaitement identiques, une différence dans la durée de fermeture des interrupteurs 4 et 24 se traduit par une élévation ou une réduction de la tension aux bornes de la capacité 40, puisque pendant un instant l'un 4 des interrupteurs est ouvert et l'autre 24 est fermé (et réciproquement). La différence de tension qui est enregistrée sur la capacité 40 est donc bien proportionnelle à la différence de durée des signaux Up et Dwn. Avec cette architecture, la conversion temps-tension et l'intégration sont donc réalisées de manière simple et compacte, mais avec une grande imprécision.

L'imprécision est due aux désappariements qui existent à plusieurs niveaux dans ce type d'architecture de l'art antérieur.

On définit deux types de désappariement. Le premier type est appelé désappariement statique, ou DS, qui correspond à la dérive de tension sur la capacité 40, lorsque les durées des signaux logiques Up et Down sont identiques. Il traduit en fait la différence entre les courants lup et Idwn qui existe du fait du désappariement des sources de courant 10 et 30. Cette différence vient principalement du fait que les sources de courant 10 et 30 sont structurellement dissymétriques, l'une étant réalisée avec des transistors NMOS, tandis que l'autre est réalisée avec des transistors PMOS. II en résulte des résistances de sortie et des tensions de polarisation différentes. De plus, on ne peut garantir l'efficacité d'une compensation mise au point en simulation, à cause des variations technologiques non corrélées.

Le second type de désappariement est le désappariement dynamique, ou DD, qui correspond au saut de tension observé sur la capacité 40 lors de la commutation des signaux Up et Dwn. De même que pour le désappariement statique, l'erreur vient du fait que les sources de courant 10 et 30 sont structurellement différentes, notamment les capacités sur les noeuds 8 et 28 sont différentes, même en réalisant l'égalité des surfaces de drain et de source des transistors des sources de courant lup 10 et Idwn 30. De plus, la mobilité des porteurs étant différente au niveau des transistors NMOS et PMOS, les temps de recouvrement en ces noeuds 8 et 28 sont dissymétriques.

De plus, lorsque l'on utilise cette structure classique en très haute fréquence, la contribution du désappariement dynamique devient importante devant les autres erreurs puisqu'elle occupe une durée relative plus importante dans le cycle d'horloge. De plus, le désappariement dynamique DD ne peut pas être compensé exactement.

On améliore l'architecture de l'art antérieur décrite ci-avant en réduisant les variations de tension aux noeuds 8 et 28 et sur les commandes des interrupteurs 4 et 24.

On peut aussi remplacer la capacité d'intégration 40 par un circuit actif possédant un amplificateur et une capacité montés en contre réaction entre l'entrée négative de l'amplificateur et la sortie dudit amplificateur. Un tel circuit actif permet de maintenir le potentiel de sortie des sources de courant constant et d'ainsi réduire le désappariement statique.

D'autres solutions ont été proposées, notamment dans les documents US 5,508,660 et EP 0 647 032.

Dans ces documents, il est décrit une architecture selon laquelle la différence entres les courants lup et Idwn est lue par un circuit de réplique fonctionnant dans les mêmes conditions que le circuit principal et donc possédant les mêmes erreurs. Cette erreur est utilisée en inversant sa polarité, dans une boucle de compensation qui est intercalée entre la sortie de la pompe de charge et les tensions de polarisation des transistors des sources de courant.

Une telle architecture ne permet d'annuler que le désappariement statique et n'est donc pas adaptée pour des fréquences élevées car le désappariement dynamique n'est pas corrigé. En effet, la structure est toujours basée sur une pompe de charge traditionnelle dans laquelle il existe une dissymétrie structurelle entres les sources de courant lup et Idwn puisqu'elles sont constituées de transistors de type différent (NMOS et PMOS).

On connaît également une architecture différentielle telle que celle décrite dans le document « A 500MHz MP/DLL Clock Generator for a 5Gb/s Backplane Transceiver in 0.25µm CMOS », ISCC 2003, auteurs : Gu-Yeon Wei, John T. Stonick, Dan Weinlader, Jeff Sonntag et Shawn Searles.

En référence à la **figure 2**, Le circuit comprend quatre interrupteurs de commande S1 à S4, les deux interrupteurs de commande S1 et S2 ayant pour entrées de commande respectivement les signaux Up et Dwn, et les deux autres S3 et S4 ayant pour entrées de commande respectivement les complémentaires Upb et Dwnb des signaux Up et Dwn.

Le circuit comprend en outre huit interrupteurs de passage de courant S5 à S12. Les interrupteurs de passage S5 et S6 sont commandés par une tension de polarisation Vb1. Les interrupteurs de passage S7 et S8 sont commandés par une tension de polarisation Vb2. Les interrupteurs de passage S9 et S10 sont commandés par une tension de polarisation Vb3. Les interrupteurs de passage S11 et S12 sont commandés par une tension de polarisation Vb4.

Des interrupteurs S13 et S14 sont pilotés par un bloc, appelé CMFB pour Common Mode FeedBack. Le bloc CMFB permet de contrôler le mode , commun en sortie, c'est-à-dire le niveau moyen des tensions de polarisations Vb1 à Vb4 qui définissent les niveaux des courants lup et Idwn.

Lorsque les signaux Up et Down sont de même polarité, aucun courant ne circule dans le filtre de boucle FB, le système est à l'équilibre.

Lorsque les signaux Up et Dwn sont opposés, les courants lup et Idwn circulent dans le filtre de boucle FB et sont intégrés pour produire une tension différentielle (Vdiff+ - Vdiff-). Cette tension différentielle est convertie en un signal par un convertisseur CDU pour commander une ligne à retard.

La structure de cette architecture différentielle est dite symétrique dans la mesure où les courants lup et Idwn sont générés à partir de transistors de dimensions et de types identiques. De même, les transistors de commande des interrupteurs de passage des courants S5 à S12 sont identiques pour les signaux Up et Dwn.

La structure permet ainsi de réduire le désappariement dynamique en équilibrant les injections de charge lors des commutations.

L'inconvénient d'une telle structure est d'une part, la nécessité de contrôler le mode commun en sortie (bloc CMFB) et d'autre part, la conception d'un bloc CDU de conversion différentiel vers unipolaire. Ces deux blocs CMFB et CDU, de conception difficile, génèrent des désappariements supplémentaires et contribuent à augmenter le désappariement statique.

La présente invention remédie à ces inconvénients.

Elle vise un convertisseur temps-tension apte à convertir la différence de durée de deux signaux logiques, en une tension proportionnelle avec une grande précision, en régime de fréquence élevée typiquement supérieur à 1 GHz.

Selon une définition générale de l'invention, le circuit de conversion temps-tension comprend deux convertisseurs temps-tension élémentaires, structurellement identiques l'un par rapport à l'autre, et possédant chacun une entrée recevant un signal de commande logique respectif et une sortie délivrant une tension représentative de la durée du signal de commande logique correspondant et un bloc différentiateur possédant des entrées positive et négative reliées chacune à une sortie d'un convertisseur élémentaire associé et une sortie délivrant un signal représentatif de la différence de tension entre les deux signaux de commande.

Une telle structure supprime la dissymétrie structurelle qui existe entre la génération des sources de courants lup et des sources de courants Idwn dans l'architecture décrite en référence à la **figure 1**.

De même, une telle structure n'utilise pas de boucle de compensation associée à cette dissymétrie comme dans le traitement différentiel de l'architecture décrite en référence à la **figure 2**.

En effet, le circuit selon l'invention propose une architecture complètement symétrique dans la phase de commutation des signaux généralement responsable du désappariement dynamique, et quasisymétrique dans la phase statique.

Ainsi, grâce à l'invention, les désappariements dynamique et statique sont structurellement supprimés.

Ainsi, la technique utilisée selon l'invention possède une meilleure immunité au bruit véhiculé sur les alimentations et le substrat puisque la structure est parfaitement symétrique pour les opérations qui nécessitent une grande précision. En effet, les parasites se retrouvent ainsi sur les deux voies et sont soustraits par un bloc différenciateur.

D'autres caractéristiques et avantages de l'invention apparaîtront à la lumière de la description détaillée ci-après et des dessins dans lesquels :
- la **figure 1**, déjà décrite, illustre une architecture d'un convertisseur temps-tension de l'art antérieur ;
- la **figure 2**, déjà décrite, illustre une architecture d'un convertisseur temps-tension de type différentiel de l'art antérieur ;
- la **figure 3** illustre schématiquement un convertisseur temps-tension symétrique selon l'invention ;
- les **figures 4A** et **4B** illustrent de manière détaillée un convertisseur temps-tension élémentaire selon l'invention ;
- la **figure 5** illustre schématiquement un générateur d'une impulsion de réinitialisation selon l'invention ;
- la **figure 6** illustre des chronogrammes des signaux de réinitialisation du générateur de la figure 5 ;
- la **figure 7** sont des chronogrammes des signaux de l'architecture de conversion temps-tension symétrique selon l'invention ; et
- la **figure 8** est un schéma bloc de l'architecture de conversion analogique-numérique utilisant un convertisseur selon l'invention.

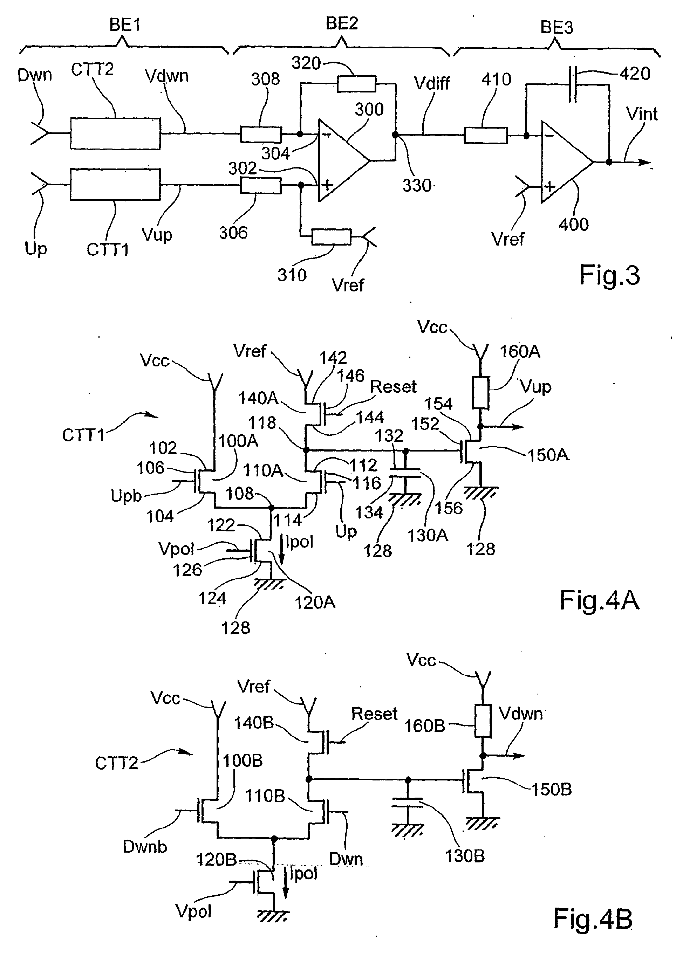

En référence à la **figure 3**, les opérations de conversion temps-tension et d'intégration sont décomposées en trois blocs élémentaires BE1 à BE3.

Le premier bloc BE1 est relatif à la conversion temps-tension sur deux voies séparées. Le bloc intermédiaire BE2 est relatif à la soustraction des tensions des voies et le bloc terminal BE3 est relatif à l'intégration de la différence.

Le bloc de conversion BE1 comprend des opérations de commutation de signaux, qui sont réalisées de manière parfaitement symétrique pour les voies séparées, ce qui supprime complètement le désappariement dynamique structurel.

Le bloc de conversion BE1 comprend deux convertisseurs temps-tension élémentaires CTT1 et CTT2, identiques, montés séparément et symétriquement en parallèle. Chaque convertisseur élémentaire CTT1 et CTT2 comprend une entrée recevant un signal de commande de polarité respectif Up ou Dwn et une sortie délivrant une tension Vup ou Vdwn représentative de la durée de chaque signal de commande.

En référence à la **figure 4A**, le convertisseur temps-tension élémentaire CTT1 comprend :
- un premier interrupteur (transistor) 100A possédant une branche d'entrée 102 (drain) connectée à une première borne d'alimentation positive Vcc, une branche de sortie 104 (source) connectée à un premier noeud intermédiaire 108 et une entrée de commande 106 (grille) recevant un signal de commande Upb,
- un second interrupteur (transistor) 110A possédant une branche d'entrée 112 connectée à un second noeud intermédiaire 118, une branche de sortie 114 (source) connectée au premier noeud intermédiaire 108 et une entrée de commande 116 (grille) recevant le complémentaire Up du signal de commande Upb du premier interrupteur 100A,
- une source de courant Ipol (transistor) 120A comprenant une branche d'entrée 122 (drain) reliée au premier noeud 108 intermédiaire, une branche de sortie 124 (source) reliée à une seconde borne d'alimentation 128 (masse), et une entrée de commande 126 (grille) reliée à une troisième borne d'alimentation Vpol,
- un condensateur 130A possédant une première borne 132 reliée au second noeud intermédiaire 118 et une seconde borne 134 reliée à la seconde borne d'alimentation 128,
- un troisième interrupteur 140A (transistor) possédant une branche d'entrée 142 (drain) connectée à une quatrième borne d'alimentation Vref, une branche de sortie 144 (source) reliée au second noeud intermédiaire 118, et une entrée de commande 146 (grille) recevant un signal de réinitialisation Reset du condensateur à la valeur de la quatrième borne d'alimentation Vref,
- un amplificateur de tension 150A (transistor) possédant une entrée de commande (grille) 152 reliée au deuxième noeud intermédiaire 118 et une sortie (drain) 154 délivrant la tension représentative Vup de la durée du signal de commande Up, la source 156 du transistor 150A étant reliée à la masse 128 et le drain 154 étant reliée à la borne d'alimentation Vcc à travers une résistance 160A.

En référence à la **figure 4B**, le convertisseur temps-tension élémentaire CTT2 comprend une structure identique à celle du convertisseur CTT1 de la **figure 4A****.** Les éléments constitutifs du convertisseur CTT2 portent les mêmes références que ceux du convertisseur CTT1 suivies de la lettre B. Le convertisseur CTT2 est associé au signal de commande Dwn et son complémentaire Dwnb.

La source de courant Ipol 120A et 120B provient soit de la borne d'alimentation Vcc lorsque les signaux de commande des interrupteurs 100A et 100B Upb et Dwnb sont actifs, soit de la capacité 130A et 130B lorsque les signaux de commande des interrupteurs Up 110A et Dwn 110B sont actifs. Les signaux Upb et Dwnb sont les signaux inverses ou complémentaires de Up et Dwn. La tension Vup et Vdwn aux bornes de la capacité 130A et 130B est donc proportionnelle au temps de fermeture de l'interrupteur 110A et 110B et donc à la durée des signaux Up et Dwn.

Cette tension Vup et Vdwn est ensuite amplifiée et remise en forme par l'amplificateur 150A et 150B avant d'être transmise au bloc soustracteur BE2.

Les capacités 130A et 130B mémorisent les tensions avant l'amplification et sont remises à la tension Vref par le signal de réinitialisation. Les tensions sont amplifiées par les transistors 150A et 150B et les résistances 160A et 160B.

La tension Vpol permet de fixer un courant Ipol dans chaque convertisseur élémentaire CTT. La tension Vcc est la tension d'alimentation générale. La tension Vref est une tension de référence inférieure à la tension d'alimentation Vcc.

La conversion temps-tension utilise une phase de réinitialisation pendant laquelle la capacité 130A et 130B est repositionnée à une valeur de référence Vref.

En pratique, les interrupteurs sont réalisés à l'aide de transistors en technologie MOS. Par exemple, tous les interrupteurs des convertisseurs CTT1 et CTT2 sont réalisés à l'aide de transistors NMOS.

La génération des signaux de commande complémentaires est en pratique réalisée à l'aide d'inverseurs.

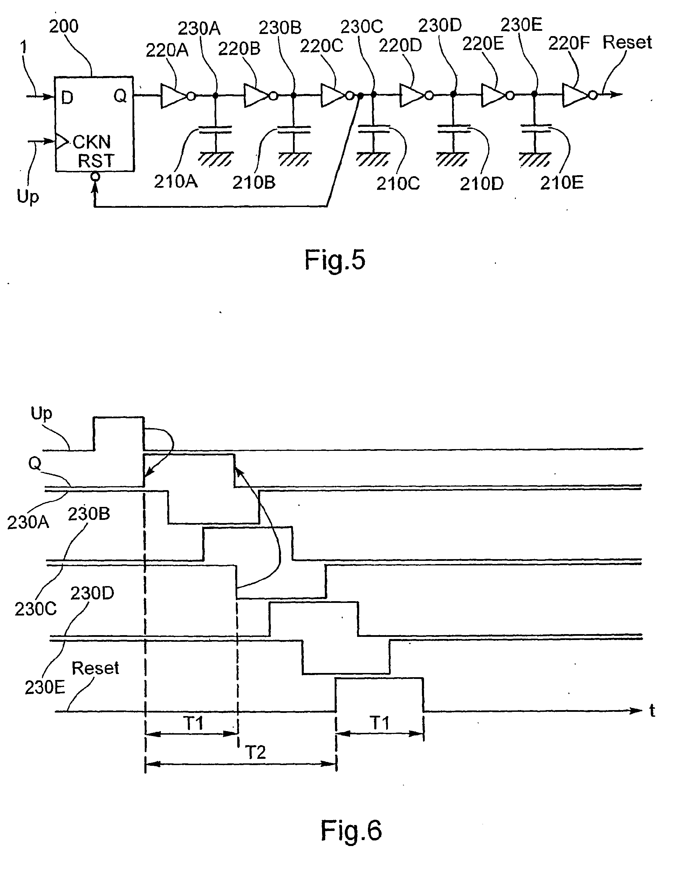

En référence à la **figure 5**, le signal de commande de réinitialisation Reset est généré par exemple par un bloc spécifique à partir du signal Up ou Dwn et comprend une bascule à front 200 et des cellules à retard montées en série et constituées chacune d'inverseurs 220 individualisés en 220A à 220E et de capacités 210, individualisées en 210A à 210E.

Par exemple, le signal de réinitialisation Reset est généré à partir du front descendant du signal Up. On peut également générer cette réinitialisation à partir du signal Dwn, car les fronts descendants des signaux Up et Dwn sont synchrones. Cette propriété est liée à l'utilisation du comparateur de phase 700.

En référence aux **figures 5** et **6**, le front descendant du signal Up déclenche l'entrée d'horloge CKN de la bascule à front 200. La sortie Q préalablement positionnée à 0, prend le niveau présent sur l'entrée D, c'est-à-dire 1. Le signal Q est ensuite retardé plusieurs fois grâce aux capacités 210A, 210B2 et 210C. Le signal présent au noeud 230C passe à 0 et remet à 0 l'entrée RST de la bascule à front 200 au bout d'un temps T1, qui correspond à la durée de l'impulsion de réinitialisation.

L'impulsion est ensuite à nouveau retardée plusieurs fois grâce aux capacités 210D et 210E. La somme de tous les retards donne le temps T2, qui correspond à l'instant de départ de l'impulsion de réinitialisation Reset.

On fait de nouveau référence à la **figure 3**. La conversion temps-tension a lieu de manière symétrique, la différence de tension Vup-Vdwn est réalisée en continu par le bloc BE2 comprenant un amplificateur soustracteur 300 possédant une entrée positive 302 recevant la tension Vup à travers une résistance 306 et une entrée négative 304 recevant la tension Vdwn à travers une résistance 308. La tension de référence Vref alimente également l'entrée positive 302 à travers une résistance 310 et la sortie 330 est reliée à l'entrée négative 304 à travers une résistance 320.

L'intégration de la différence est réalisée en continu par un intégrateur BE3 comprenant un amplificateur 400 à montage actif de type résistance 410 et capacité 420.

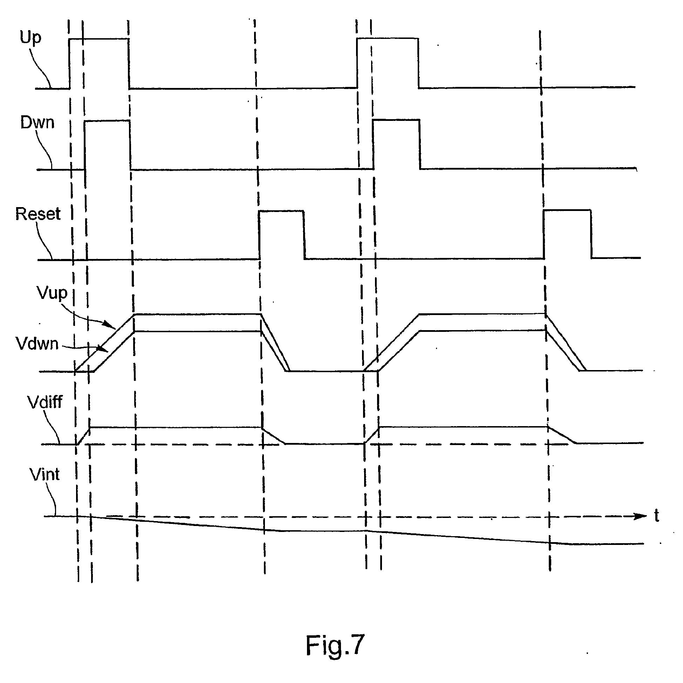

En référence à la **figure 7**, les chronogrammes sont illustrés pour un signal Up ayant une durée supérieure au signal Dwn. Après une conversion temps-tension selon l'invention, les tensions Vup et Vdwn présentent des niveaux différents proportionnels à la durée des signaux Up et Dwn. Ces tensions sont remises à un niveau de référence par le signal de réinitialisation Reset.

La différence Vdiff=Vup-Vdwn est donc positive et va donc incrémenter la tension de sortie Vint de l'intégrateur BE3. Ici, la tension Vint évolue dans le sens opposé à Vdiff car le montage intégrateur est inverseur.

La présente invention peut être intégrée dans la technique de numérisation utilisée dans la voie réception d'un transmetteur fonctionnant en Ultra Large Bande (ULB ou UWB). Dans cette technique, on numérise sur 1bit un signal UWB à la fréquence de 20GHz.

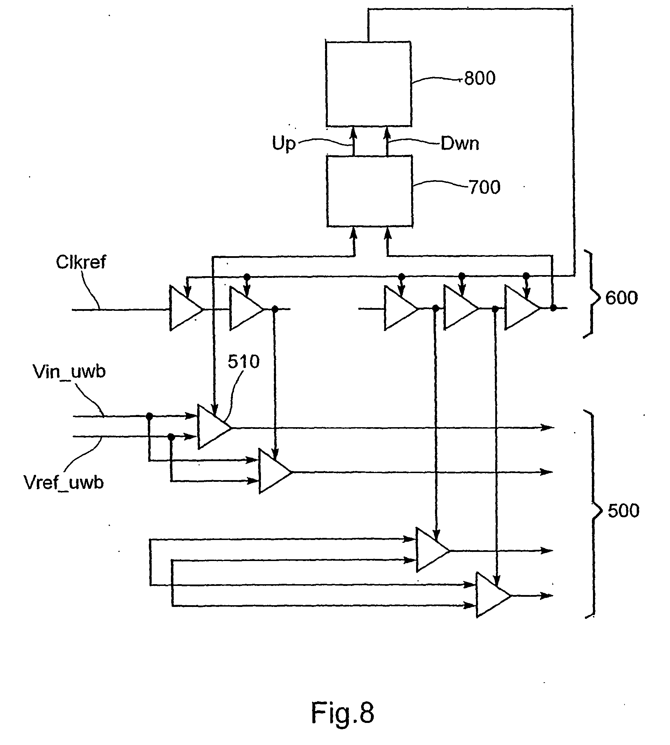

En référence à la **figure 8**, l'architecture de conversion d'un système UWB comprend un convertisseur 500 analogique-numérique 1 bit à 20 GHz, et une boucle à verrouillage de retard (DLL). Cette boucle comporte des lignes à retard 600 commandées en tension, un comparateur de phase 700 et un convertisseur temps-tension 800 réalisé selon l'invention.

La conversion 1 bit à 20 GHz est effectuée à plus basse fréquence pour des raisons de limitation technologique. On génère par exemple 16 horloges à la fréquence de 1,25 GHz, décalée de 50 ps. On obtient ainsi un convertisseur analogique-numérique 1 bit fonctionnant à 20 GHz constitué de 16 comparateurs montés en parallèle et commandés par les 16 horloges décalées.

Un des points critiques sur la précision globale du système est le décalage de 50 ps. Il est nécessaire d'utiliser une boucle à asservissement de phase pour contrôler ce délai et générer les 16 horloges.

Le signal analogique à convertir est Vin_uwb. Il est comparé à une tension Vref_uwb grâce à 16 comparateurs 510 positionnés en parallèle et qui sont activés à la fréquence de 1,25GHz en décalage de 50ps. Les résultats des 16 conversions sont envoyés sur un bloc logique pour la remise en forme et l'exploitation.

Les 16 horloges décalées de 50ps sont générées par la boucle à asservissement de phase, constituée d'une ligne à retards 600 commandés en tension, d'un comparateur de phase 700 et d'un convertisseur temps-tension 800 réalisé selon l'invention.

Le circuit 800 selon l'invention intégré dans la boucle à asservissement de phase entre le comparateur de phase 700 qui génère les signaux Up et Dwn et la ligne à retard 600 commandée en tension, permet donc de fournir la précision souhaitée à la fréquence de fonctionnement de 1,25GHz.

La technique utilisée selon l'invention possède une meilleure immunité au bruit véhiculé sur les alimentations et le substrat puisque la structure est parfaitement symétrique pour les opérations qui nécessitent une grande précision. En effet, les parasites se retrouvent ainsi sur les deux voies CTT1 et CTT2 séparées et sont soustraits par le bloc différenciateur BE2.

## Revendications

1. Circuit de conversion temps-tension comprenant deux convertisseurs temps-tension élémentaires (CTT1 et CTT2), structurellement identiques l'un par rapport à l'autre, et possédant chacun une entrée recevant un signal de commande logique respectif (Up et Dwn) et une sortie délivrant une tension représentative de la durée du signal de commande logique (Vup et Vdwn) correspondant et un bloc différentiateur (BE2) possédant des entrées positive (302) et négative (304) reliées chacune à une sortie d'un convertisseur élémentaire associé (CTT1 et CTT2) et une sortie délivrant un signal (Vdiff) représentatif de la différence de tension entre les deux signaux de commande (Up et Dwn).

2. Circuit selon la revendication 1 dans lequel la sortie du bloc différentiateur est reliée à un bloc intégrateur (BE3).

3. Circuit selon la revendication 1 dans lequel le bloc différentiateur (BE2) est un amplificateur soustracteur (300).

4. Circuit selon la revendication 2 ou la revendication 3 dans lequel le bloc intégrateur (BE3) est un amplificateur (400) actif de type RC.

5. Circuit selon l'une des revendications 1 à 4 dans lequel les signaux de commande (Up et Dwn) sont issus d'un comparateur de phase (700).

6. Circuit selon la revendication 1 **caractérisé en ce que** chaque convertisseur temps-tension élémentaire (CTT1 et CTT2) comprend :
- un premier interrupteur (100A, 100B) possédant une branche d'entrée (102) connectée à une première borne d'alimentation (Vcc), une branche de sortie (104) connectée à un premier noeud intermédiaire (108) et une entrée de commande (106) recevant un signal de commande (Upb,Dwnb) ;
- un second interrupteur (110A, 110B) possédant une branche d'entrée (112) connectée à un second noeud intermédiaire (118), une branche de sortie (114) connectée au premier noeud intermédiaire (108) et une entrée de commande (116) recevant le complémentaire (Up, Dwn) du signal de commande (Upb, Dwnb) du premier interrupteur (100A, 100B) ;
- une source de courant (120A, 120B) comprenant une branche d'entrée (122) reliée au premier noeud intermédiaire (108), une branche de sortie (124) reliée à une seconde borne d'alimentation (128), et une entrée de commande (126) reliée à une troisième borne d'alimentation (Vpol) ;
- un condensateur (130A, 130B) possédant une première borne (132) reliée au second noeud intermédiaire (118) et une seconde borne (134) reliée à la seconde borne d'alimentation (128) ;
- un troisième interrupteur (140A, 140B) possédant une branche d'entrée (142) connectée à une quatrième borne d'alimentation (Vref), une branche de sortie (144) reliée au second noeud intermédiaire (118), et une entrée de commande (146) recevant un signal de réinitialisation (Reset) du condensateur à la valeur de la quatrième borne d'alimentation (Vref) ;
- un amplificateur de tension (150A, 150B) possédant une entrée de commande (152) reliée au deuxième noeud intermédiaire (118) et une sortie (154) délivrant la tension représentative (Vup, Vdwn) de la durée du signal de commande (Up, Dwn).

7. Circuit selon la revendication 6 dans lequel le signal de réinitialisation (Reset) est réalisé à l'aide d'une bascule à front (200) et de cellules à retard (210, 220).

## Claims

1. Time/voltage conversion circuit including two structurally identical basic time/voltage converters (CTT1 and CTT2) each having an input receiving a respective logic control signal (Up and Dwn) and an output delivering a voltage representative of the duration of the corresponding logic control signal (Vup and Vdwn) and a differentiator block (BE2) having a positive input (302) and a negative input (304) each connected to an output of an associated basic converter (CTT1 and CTT2) and an output delivering a signal (Vdiff) representative of the voltage difference between the two control signals (Up and Dwn) .

2. Circuit according to claim 1, wherein the output of the differentiator block is connected to an integrator block (BE3).

3. Circuit according to claim 1, wherein the differentiator block (BE2) is a subtractor amplifier (300).

4. Circuit according to claim 2 or claim 3, wherein the integrator block (BE3) is an active amplifier (400) of RC type.

5. Circuit according to any one of claims 1 to 4, wherein the control signals (Up and Dwn) are obtained from a phase comparator (700),

6. A circuit according to claim 1, **characterized in that** each basic time/voltage converter (CTT1 and CTT2) includes:
- a first switch (100A, 100B) having an input branch (102) connected to a first power supply terminal (Vcc), an output branch (104) connected to a first intermediate node (lows), and a control input (106) receiving a control signal (Upb, Dwnb);
- a second switch (110A, 110B) having an input branch (112) connected to a second intermediate node (118), an output branch (114) connected to the first intermediate node (108), and a control input (116) receiving the compliment (Up, Dwn) of the control signal (Upb, Dwnb) of the first switch (100A, 100B);
- a current source (120A, 120B) including an input branch (122) connected to the first intermediate node (108), an output branch (124) connected to a second power supply terminal (128), and a control input (126) connected to a third power supply terminal (Vpol);
- a capacitor (130A, 130B) having a first terminal (132) connected to the second intermediate node (118) and a second terminal (134) connected to the second power supply terminal (128);
- a third switch (140A, 140B) having an input branch (142) connected to a fourth power supply terminal (Vref) , an output branch (144) connected to the second intermediate node (118), and a control input (146) receiving a signal (Reset) for resetting the capacitor to the value at the fourth power supply terminal (Vref);
- a voltage amplifier (150A, 150B) having a control input (152) connected to the second intermediate node (118) and an, output (154) delivering the voltage (Vup, Vdwn) representative of the duration of the control signal (Up, Dwn).

7. Circuit according to claim 6, wherein the resetting signal (Reset) is produced by an edge-triggered flip-flop (200) and delay cells (210, 220).

## Patentansprüche

1. Zeit/Spannungs-Umsetzungsschaltung, umfassend zwei Zeit/ Spannungs-Einzelwandler (CTT1 und CTT2), die strukturell in Bezug aufeinander identisch sind und jeweils einen Eingang, der ein jeweiliges logisches Steuersignal (Up und Dwn) empfängt, und einen Ausgang besitzen, der eine für die Dauer des entsprechenden logischen Steuersignals repräsentative Spannung (Vup und Vdwn) liefert, und einen Differenzblock (BE2), der einen positiven Eingang (302) und einen negativen Eingang (304), die jeweils mit einem Ausgang eines zugeordneten Einzelwandlers (CTT1 und CTT2) verbunden sind, und einen Ausgang besitzt, der ein Signal (Vdiff) liefert, das für die Spannungsdifferenz zwischen den beiden Steuersignalen (Up und Dwn) repräsentativ ist.

2. Schaltung nach Anspruch 1, bei der der Ausgang des Differenzblocks mit einem Integrierblock (BE3) verbunden ist.

3. Schaltung nach Anspruch 1, bei der der Differenzblock (BE2) ein Subtrahierverstärker (300) ist.

4. Schaltung nach Anspruch 2 oder Anspruch 3, bei der der Integrierblock (BE3) ein aktiver RC-Verstärker ist.

5. Schaltung nach einem der Ansprüche 1 bis 4, bei der die Steuersignale (Up und Dwn) von einem Phasenvergleicher (700) kommen.

6. Schaltung nach Anspruch 1, **dadurch gekennzeichnet, dass** jeder Zeit/Spannungs-Einzelwandler (CTT 1 und CTT2) umfasst:
- einen ersten Schalter (100A, 100B), der einen Eingangszweig (102), der mit einem ersten Versorgungsanschluss (Vcc) verbunden ist, einen Ausgangszweig (104), der mit einem ersten Zwischenknoten (108) verbunden ist, und einen Steuereingang (106) besitzt, der ein Steuersignal (Upb, Dwnb) empfängt;
- einen zweiten Schalter (110A, 110B), der einen Eingangszweig (112), der mit einem zweiten Zwischenknoten (118) verbunden ist, einen Ausgangszweig (114), der mit dem ersten Zwischenknoten (108) verbunden ist, und einen Steuereingang (116) besitzt, der das Komplement (Up, Dwn) des Steuersignals (Upb, Dwnb) des ersten Schalters (100A, 100B) empfängt;
- eine Stromquelle (120A, 120B), die einen Eingangszweig (122), der mit dem ersten Zwischenknoten (108) verbunden ist, einen Ausgangszweig (124), der mit einem zweiten Versorgungsanschluss (128) verbunden ist, und einen Steuereingang (126) besitzt, der mit einem dritten Versorgungsanschluss (Vpol) verbunden ist;
- einen Kondensator (130A, 130B), der einen ersten Anschluss (132), der mit dem zweiten Zwischenknoten (118) verbunden ist, und einen zweiten Anschluss (134) besitzt, der mit dem zweiten Versorgungsanschluss (128) verbunden ist;
- einen dritten Schalter (140A, 140B), der einen Eingangszweig (142), der mit einem vierten Versorgungsanschluss (Vref) verbunden ist, einen Ausgangszweig (144), der mit dem zweiten Zwischenknoten (118) verbunden ist, und einen Steuereingang (146) besitzt, der ein Signal (Reset) zur Reinitialisierung des Kondensators auf den Wert des vierten Versorgungsanschlusses (Vref) empfängt;
- einen Spannungsverstärker (150A, 150B), der einen Steuereingang (152), der mit dem zweiten Zwischenknoten (118) verbunden ist, und einen Ausgang (154) besitzt, der die für die Dauer des Steuersignals (Up, Dwn) repräsentative Spannung (Vup, Vdwn) liefert.

7. Schaltung nach Anspruch 6, bei der das Reinitialisierungssignal (Reset) mit Hilfe einer Front-Kippschaltung (200) und von Verzögerungszellen (210, 220) hergestellt ist.
